# EUROPÄISCHE PATENTSCHRIFT

(11) **EP 1 124 325 B1**
(45) Veröffentlichungstag und Bekanntmachung des Hinweises auf die Patenterteilung: **14.03.2007**
(21) Anmeldenummer: 01100600.4
(22) Anmeldetag: 10.01.2001
(51) Int. Cl.: H03F 3/26

(54) **Hochfrequenz-Gegentaktverstärker**
High frequency push-pull amplifier
Amplificateur en montage push-pull à haute fréquence

(30) Priorität: 10.02.2000 DE 10005805
(43) Veröffentlichungstag der Anmeldung: 16.08.2001
(73) Patentinhaber: Rohde & Schwarz GmbH & Co. KG, 81671 München (DE)
(72) Erfinder: Hupfer, Konrad, 85435 Erding (DE)
(74) Vertreter: Körfer, Thomas

(56) Entgegenhaltungen:
- EP-A- 0 302 162
- US-A- 4 945 317
- US-A- 5 495 212

## Beschreibung

Die Erfindung betrifft einen Hochfrequenz-Gegentaktverstärker großer Bandbreite.

Bei Senderendstufen ist es oftmals erforderlich, die beispielsweise als Transistor-Gegentakt-Verstärkerschaltung ausgebildete Leistungsendstufe mit einer Leistung von beispielsweise 10 bis 30 W in einem breiten Frequenzband von beispielsweise 1,5 bis 600 MHz mit gutem Wirkungsgrad zu betreiben. Mit den bekannten Anpassschaltungen, bei denen am symmetrischen Ausgang des Gegentakt-Transistor-Verstärkers ein ggf. auch transformierender Symmetrierübertrager (Balun) angeordnet ist (beispielsweise nach US-A-4,945,317) ist diese Breitbandigkeit nicht erreichbar, auch wenn zwischen dem symmetrischen Ausgang des Gegentaktverstärkers und der unsymmetrischen Last die Hintereinanderschaltung eines Impedanztransformators und eines Symmetrierübertragers vorgesehen ist (US-A-4,945,317).

Bei einer Symmtrierübertrageranordnung zur Verbindung einer unsymmetrischen Leitung mit einer symmetrischen Leitung ist es an sich bekannt, zur Störfrequenzreduktion zusätzlich zu dem transformierenden Symmetrierübertrager (Balun) in Reihe hierzu auf der symmetrischen Seite der Anordnung eine Dämpfungsdrossel (Choke) anzuordnen, die einen Kern aufweist, der aus einem ersten Teil von hoher Permeabilität und einem zweiten Teil von niedriger Permeabilität besteht (US-A-5,495,212). Diese Drossel besitzt damit auf der symmetrischen Seite für unsymmetrische Signale, die charakteristisch sind für Störfrequenzen, eine sehr hohe Impedanz während sie für symmetrische Nutzsignale eine sehr niedrige Impedanz aufweist. Diese bekannte Anordnung mit einem gemischten Kern sowohl hoher als auch niedriger Permeabilität ist für den erfindungsgemäßen Zweck nicht geeignet. Dies gilt auch für eine andere bekannte Anpassschaltung (europäische Patentanmeldung EP-A-0 302 162), bei der zwei Symmetrierübertrager in Reihe hintereinander geschaltet sind und der erste Transformator für Frequenzen über 1 MHz und der nachfolgende zweite Transformator für Mittelfrequenzen zwischen 10 KHz und 1 MHz vorgesehen ist.

Es ist Aufgabe der Erfindung, einen Hochfrequenz-Gegentaktverstärker großer Bandbreite mit gutem Wirkungsgrad zu schaffen.

Diese Aufgabe wird durch einen Hochfrequenz-Gegentaktverstärker laut Anspruch 1 gelöst. Vorteilhafte Weiterbildungen ergeben sich aus den Unteransprüchen.

Die erfindungsgemäße Aufgabe wird laut Hauptanspruch erst dadurch gelöst, dass zwei getrennte Symmetrierübertrager hintereinander geschaltet werden, von denen der erste eingangsseitig mit dem symmetrischen Ausgang des Gegentaktverstärkers verbundene Symmetrierübertrager keinen gemischten Kern sondern nur einen Ferritkern von relativ niedriger Permeabilität aufweist, während der zweite darauf folgende Symmetrierübertrager, der ausgangsseitig mit der unsymmetrischen Last verbunden ist, ebenfalls keinen Mischkern aufweist sondern nur einen Ferritkern von relativ hohe Permeabilität. Damit wirken diese beiden hintereinander geschalteten Symmetrierübertrager jeweils voneinander unabhängig und es wird erreicht, dass der zweite Symmetrierübertrager, durch den der symmetrische Ausgang des Leistungstransistors in den unsymmetrischen Ausgang gewandelt wird, durch den ersten Symmetrierübertrager vom Gegentaktverstärker-Ausgang isoliert wird. Der zweite Symmetrierübertrager kann damit mit einem Ferritkern von relativ hoher Permeabilität hergestellt werden, der bei niedrigen Frequenzen unterhalb beispielsweise 200 MHz verhältnismäßig große Verluste aufweisen kann. Als besonders vorteilhaft hat es sich erwiesen, den ersten Symmetrierübertrager nicht nur mit einem Ferritkern mit relativ niedriger Permeabilität aufzubauen, sondern ihn gleichzeitig so auszubilden, dass er für hohe Frequenzen als Transformator wirkt. Der Aufbau der Symmetrierübertrager erfolgt ansonsten in bekannter Weise.

Die Erfindung wird im Folgenden anhand einer schematischen Zeichnung an einem Ausführungsbeispiel näher erläutert.

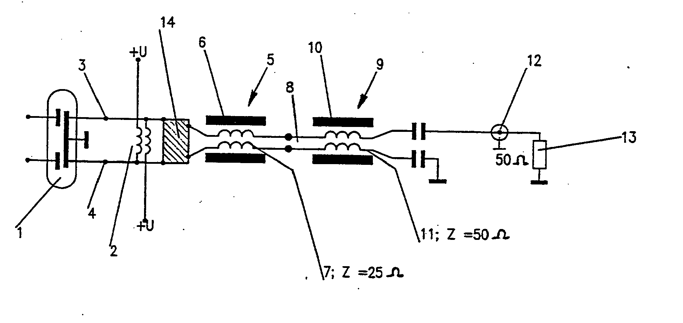

Die Figur zeigt das Prinzipschaltbild einer Hochfrequenz-Transistor-Gegentakt-Verstärkerschaltung für einen breiten Frequenzbereich beispielsweise von 1,5 bis 600 MHz. Der Transistor 1 wird in bekannter Weise über eine bifilare Drosselanordnung 2 mit seiner Betriebsspannung gespeist, sein symmetrischer Ausgang 3, 4 ist mit dem Eingang eines ersten transformierenden Symmetrierübertragers 5 verbunden, der aus einem Ferritkern 6, beispielsweise einem sogenannten Nasenlochkern, und einer als Koaxialkabel ausgebildeten Doppeldrahtwicklung 7 besteht. Der symmetrische Ausgang 8 dieses ersten transformierenden Symmetrierübertragers ist mit dem Eingang eines zweiten Symmetrierübertragers 9 verbunden, der seinerseits aus einem Ferritkern 10 und einer wiederum als Koaxialkabel ausgebildeten Doppeldraht-Wicklung 11 besteht. Dieser zweite Symmetrierübertrager ist mit dem Ausgang 12 verbunden, an dem eine Last 13 von 50 Ohm angeschaltet ist.

Der Ferritkern 6 des ersten Symmetrierübertragers besitzt eine relativ kleine Permeabilität von beispielsweise µ = zwischen 80 und 150, hat also bei hohen Frequenzen geringe Verluste. Der Wellenwiderstand Z des Koaxialkabels 7 beträgt Z = 25 Ohm und hat eine Länge λ/4 in der Nähe der höchsten Operationsfrequenz von beispielsweise 600 MHz. Damit wirkt dieser Symmetrierübertrager für hohe Frequenzen als 4.1-Transformator und dem Ausgang 3, 4 des Transistors 1 wird somit für hohe Frequenzen ein günstiger Ausgangswiderstand von 12,5 Ohm angeboten. Bei tieferen Frequenzen wirkt dieser Symmetrierübertrager 5 nicht mehr transformierend, dem Ausgang 3, 4 des Transistors wird damit für tiefe Frequenzen der Eingang des zweiten Symmetrierübertragers 9 von 50 Ohm angeboten. Zur Verfeinerung der Anpassung in Frequenzbereichen, in denen die λ/4 Transformation des Symmetrierübertragers 5 bereits stark abnimmt, kann zwischen Transistor 1 und erstem Symmetrierübertrager 5 noch ein zusätzliches L/C-Transformator-Netzwerk 14 angeordnet werden. Der Wellenwiderstand der Wicklung 11 des zweiten Symmetrierübertragers 9 ist Z = 50 Ohm gewählt und dieser Symmetrierübertrager dient daher nur zur Umwandlung des symmetrischen Ausgangs des Transistors auf den unsymmetrischen Lastwiderstand 13.

## Patentansprüche

1. Hochfrequenz-Gegentaktverstärker, dessen symmetrischer Ausgang (3, 4) über eine Symmetrierübertrageranordnung mit einer unsymmetrischen Last (13) verbunden ist,
wobei die Symmetrierübertrageranordnung aus der Hintereinanderschaltung von zwei Symmetrierübertragern (5, 9) besteht,
wobei der erste eingangsseitig mit dem symmetrischen Ausgang (3, 4) des Gegentaktverstärkers (1) verbundene Symmetrierübertrager nur einen Ferritkern (6) von relativ niedriger Permeabilität aufweist und der zweite Symmetrierübertrager (9) eingangsseitig mit dem symmetrischen Ausgang (8) des ersten Symmtrierübertragers und ausgangsseitig mit der Last (13) verbunden ist und nur einen Ferritkern (10) von relativ hoher Permeabilität aufweist, und
wobei der erste Symmetrierübertrager (5) so ausgebildet ist, dass er für hohe Frequenzen als Transformator wirkt.

2. Hochfrequenz-Gegentaktverstärker nach Anspruch 1,
**dadurch gekennzeichnet,**
**dass** die Wicklung (7) des ersten Symmetrierübertragers (5) einen Wellenwiderstand von 25 Ohm und für hohe Frequenzen eine Länge von λ/4 aufweist und dies Wicklung (11) des zweiten Symmetrierübertragers (9) einen Wellenwiderstand von 50 Ohm aufweist.

3. Hochfrequenz-Gegentaktverstärker nach Anspruch 1 oder 2,
**dadurch gekennzeichnet,**
**dass** der Ferritkern des ersten Symmetrierübertragers (5) eine Permeabilität etwa zwischen 80 und 150 und der Ferritkern des zweiten Symmetrierübertragers eine Permeabilität von etwa 800 aufweist.

## Claims

1. High-frequency push-pull amplifier, the symmetric output (3, 4) of which is connected to an asymmetric load (13) via a balancing transformer arrangement,
wherein the balancing transformer set-up comprising the series connection of two balancing transformers (5, 9),
wherein the balancing transformer which is first connected on the input side to the symmetric output (3, 4) of the push-pull amplifier (1) only has a ferrite core (6) of relatively low permeability and the second balancing transformer (9) is connected on the input side with the symmetric output (8) of the first balancing transformer and on the output side with the load (13) and only has a ferrite core (10) of relatively high permeability, and
wherein the first balancing transformer (5) is designed, so that it functions as a transformer for high frequencies.

2. High frequency push pull amplifier according to claim 1,
**characterised in that,**
the winding (7) of the first balancing transformer (5) has a characteristic impedance of 25 Ohm and for high frequencies a longitude of λ/4 and this winding (11) of the second symmetric transformer (9) has a characteristic impedance of 50 Ohm.

3. High-frequency push-pull amplifier according to claim 1 or 2,
**characterised in that,**
the ferrite core of the first balancing transformers (5) has a permeability of approx. between 80 and 150 and the ferrite core of the second balancing transformer has a permeability of about 800.

## Revendications

1. Amplificateur en montage push-pull à haute fréquence dont la sortie symétrique (3, 4) est reliée à une charge asymétrique (13) par l'intermédiaire d'un ensemble de transformateurs d'équilibrage, dans lequel l'ensemble de transformateurs d'équilibrage est réalisé par la disposition l'un derrière l'autre de deux transformateurs d'équilibrage (5, 9) dans lequel le premier transformateur d'équilibrage relié du côté entrée avec la sortie symétrique (3, 4) de l'amplificateur en montage push-pull (1) ne comprend qu'un noyau en ferrite (6) d'une perméabilité relativement faible et le deuxième transformateur d'équilibrage (9) est relié du côté entrée avec la sortie symétrique (8) du premier transformateur d'équilibrage et du côté sortie avec la charge (13) et ne comprend qu'un noyau en ferrite (10) d'une perméabilité relativement élevée et dans lequel le premier transformateur d'équilibrage est configuré de telle façon qu'il agisse comme transformateur pour les fréquences élevées.

2. Amplificateur en montage push-pull à haute fréquence selon la revendication 1, **caractérisé en ce que** le bobinage (7) du premier transformateur d'équilibrage (5) a une impédance caractéristique de 25 ohms et pour les hautes fréquences une longueur de λ/4 et **en ce que** le bobinage (11) du deuxième transformateur d'équilibrage (9) a une impédance caractéristique de 50 ohms.

3. Amplificateur en montage push-pull à haute fréquence selon la revendication 1 ou 2, **caractérisé en ce que** le noyau en ferrite du premier transformateur d'équilibrage (5) a une perméabilité située environ entre 80 et 150 et **en ce que** le noyau en ferrite du deuxième transformateur d'équilibrage à une perméabilité d'environ 800.
